# EUROPEAN PATENT APPLICATION

(11) **EP 3 703 253 A1**
(43) Date of publication of application: **02.09.2020**
(21) Application number: 17930782.2
(22) Date of filing: 30.10.2017
(51) Int. Cl.: H02S 40/22, H01L 31/052

(54) **LIGHT-CONCENTRATING SOLAR ENERGY SYSTEM**

(71) Applicant: Bolymedia Holdings Co., Ltd., Santa Clara, CA 95051 (US)
(72) Inventor: HU, Xiaoping, Shenzhen, Guangdong 518109 (CN)
(74) Representative: Manitz Finsterwald Patent- und Rechtsanwaltspartnerschaft mbB
(86) International application number: PCT/CN2017/108251
(87) International publication number: WO 2019/084707

(57) **Abstract**

Provided is a light-concentrating solar energy system, comprising a pair of outer reflective elements (110, 110'), a pair of inner reflective elements (120, 120') and a solar energy utilization device (130), wherein each pair of reflective elements comprises two reflective elements which are arranged opposite to each other in a tilted manner, and one end thereof with a larger opening is an upper end, which faces a sunlight (LL) incident direction; the pair of inner reflective elements (120, 120') is arranged between the pair of outer reflective elements (110, 110'); and a light receiving surface (131) of the solar energy utilization device (130) is arranged at a lower end of the pair of outer reflective elements (110, 110'), and the inner reflective elements (120, 120') are located on the light receiving surface (131). The system can realize a relatively high light-concentrating ratio and light-concentrating efficiency at a lower cost.

## Description

### TECHNICAL FIELD

The present disclosure relates to clean energy and in particular to light-concentrating solar energy systems.

### BACKGROUND

With increasing focus on environmental protection, solar energy systems are growing in popularity. Currently conventional solar energy systems that directly use photovoltaic panels as an original solar energy collecting surface have been difficult to continue to reduce costs; whereas light-concentrating solar energy systems are receiving more and more attention because they can improve the efficiency of solar energy utilization and reduce overall costs.

For example, a light-concentrating solar system using light guide was disclosed in a PCT patent application WO2017015901A1 entitled "ENCLOSED SOLAR ENERGY UTILIZATION DEVICE AND SYSTEM" and published on Feb. 2, 2017. It is necessary to conduct further research to make the above schemes more complete or obtain higher cost performance.

### SUMMARY

According to the present disclosure, a light-concentrating solar energy system is provided, which includes a pair of outer reflective elements, a pair of inner reflective elements and a solar energy utilization device. Each pair of reflective elements includes two pieces of reflective elements which are arranged opposite to each other in a tilted manner. The ends of each pair of tilted reflective elements forming a larger opening are the upper ends thereof, the upper ends face a direction in which sunlight is incident. A pair of inner reflective elements are disposed between a pair of outer reflective elements. The opposite surfaces of a pair of outer reflective elements are reflective surfaces. The opposing surfaces of a pair of inner reflective elements are reflective surfaces, or both surfaces are reflective surfaces. Each reflective surface is a plane or a curved surface. The light receiving surface of the solar energy utilization device is arranged at the lower end of the pair of outer reflective elements, and the inner reflective element is arranged above the light receiving surface.

According to the light-concentrating solar energy system of the present disclosure, there are two pairs of inner and outer reflective elements. Compared with a light guide or a condenser tube having only one pair of reflective elements, the system herein can be achieved with a higher light-concentration ratio and light-concentrating efficiency at a lower cost; and moreover, it has stronger adaptability to solar deflection and helps to improve the incident angle of sunlight received by the light receiving surface of solar energy utilization device, thereby reducing the reflection loss of the light receiving surface and improving the solar energy utilization efficiency.

Preferably, the system may further include a Fresnel lens parallel to or perpendicular to the light receiving surface of the solar energy utilization device, so as to improve the light-concentration ratio of the system or enhance the adaptation range to the solar irradiation angle.

Specific examples according to the present disclosure are described in detail below with reference to the accompanying drawings. As used herein, terms that indicate a position, such as "upper", "lower", "left", "right", "top", "bottom", "side", "vertical", "parallel" and the like, only refer to relative positional relationships, having no absolute meanings. The serial numbers or sequence numbers used herein, such as "first", "second", etc., are merely illustrative without any restrictive meanings.

### BRIEF DESCRIPTION OF THE DRAWINGS

FIG. 1 is a schematic diagram of a light-concentrating solar energy system in Embodiment 1;
FIG. 2 is a schematic diagram of a light-concentrating solar energy system in Embodiment 2;
FIG. 3 is a schematic diagram of a light-concentrating solar energy system in Embodiment 3; and
FIG. 4 is a schematic diagram of a light-concentrating solar energy system in Embodiment 4;

### DETAILED DESCRIPTION

### Embodiment 1

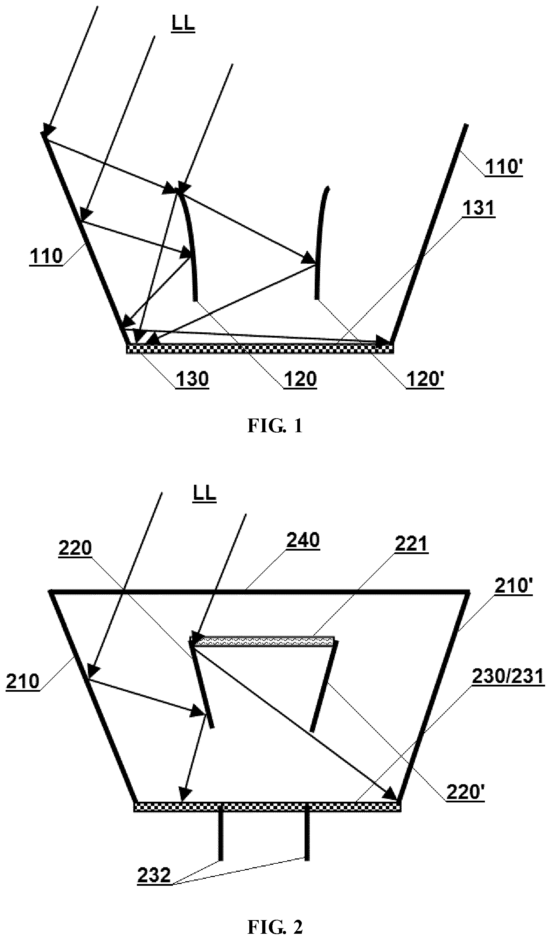

Referring to FIG. 1, a light-concentrating solar energy system according to one embodiment of the present disclosure may is schematically illustrated in a longitudinal section thereof. The light-concentrating solar energy system may include a first pair of outer reflective element 110,110', a first pair of inner reflective element 120,120' and a solar energy utilization device 130.

Each pair of reflective elements may include two reflective elements which are arranged opposite to each other in a tilted manner. The ends of each pair of tilted reflective elements forming a larger opening are the upper ends thereof; and the sunlight LL irradiated onto the reflective element from the upper ends is guided to corresponding lower ends.

The surfaces of the outer reflective elements 110,110' which face each other are reflective surfaces. The inner reflective elements 120,120' are arranged between the outer reflective elements 110,110', and their surfaces face each other are reflective surfaces. In a preferred embodiment such as the present embodiment, the surfaces of the inner reflective elements 120,120' facing the outer reflective elements are also referred to as reflective surfaces so as to assist the outer reflective elements to guide the sunlight downward.

The reflective surface of each reflective element can be flat or curved. For example, in this embodiment, the reflective surfaces of the outer reflective elements are planes, forming a trumpet-shaped opening on the outside; and the reflective surfaces of the inner reflective elements are smoothly curved surfaces, forming a trumpet-shaped opening on the inside. Each reflective surface can be arbitrarily selected in various types, but parameters including the slope of the plane or the curvature of the curved surface need to be configured according to the requirements of the optical design such that the sunlight irradiated onto the reflective surfaces can be focused on the solar energy utilization device.

The light receiving surface 131 of the solar energy utilization device 130 is arranged at the lower ends of the outer reflective elements 110,110', and the inner reflective elements 120,120' are arranged above the light receiving surface 131. For example, the inner reflective elements may be fixed on the light receiving surface 131 by a transparent support (not shown), or the inner reflective elements may be fixed at sides (i.e. both ends of the inner reflective elements extending laterally). The solar energy utilization device which is a photovoltaic panel in this embodiment may generally refer to any photovoltaic conversion device including various semiconductor photovoltaic panels, photovoltaic thin films, quantum dot photovoltaic conversion device and photoelectric conversion materials. In other embodiments, since the solar system according to the present disclosure can obtain light-concentration ratio, the solar energy utilization device may also include a thermoelectric conversion device or a heat energy utilization device to achieve higher solar energy utilization efficiency, wherein the heat energy utilization device may include a water heater or a thermal energy generator (such as a Stirling generator or a steam generator).

The photovoltaic panel 130 and the outer reflective elements 110,110' on both ends are formed into a wedge-shaped groove, and sunlight from the larger opening (i.e. the upper end) is converged to the bottom. The introduction of the inner reflective elements 120,120' disposed inside the groove can increase the flare angle of the outer reflective element, thereby improving the light-concentration ratio and the ability to the sun's declination; further, the introduction may also enhance the incident angle of the sunlight irradiated on the light receiving surface 131, resulting in decrease of reflection loss and increase of solar energy utilization efficiency.

A basic form of the solar energy system is shown in this embodiment according to the present disclosure, and various changes or improvements can be made on this basis to meet different needs or to achieve better results; for example, providing a top cover on the top of the system, or adding more effective optical elements (such as Fresnel lenses) to a light path that converges the light.

### Embodiment 2

Referring to FIG. 2, a light-concentrating solar energy system according to another embodiment of the present disclosure may is schematically illustrated in a longitudinal section thereof. The light-concentrating solar energy system may include a first pair of outer reflective element 210,210', a first pair of inner reflective element 220,220' and a photovoltaic panel 230.

The difference between this embodiment and Embodiment 1 is that each reflective surface is a plane, which makes it easy to fabricate a reflective element. Preferably, to obtain a larger light-concentration ratio, the angle between the outer reflective element and the light receiving surface 231 of the photovoltaic panel 230 may be greater than or equal to the angle between the inner reflective element and the receiving surface 231. The angle between two planes referred to herein refers to the angle between the two planes that is less than or equal to 90 degrees.

In addition:
In a preferred embodiment such as the present embodiment, a transparent top cover 240 may further provided to enclose the upper ends of the outer reflective elements 210,210'. It may be made of glass or plastic. The transparent top cover can reduce the impact of dust and the surroundings on the reflective surface and the solar energy utilization device, which is easy to clean and helps to extend the life of the system. Further preferably, the system can be integrally formed as a closed container, for example, the lower end of the first pair of outer reflective elements is closed with the light receiving surface of the solar energy utilization device, and both sides of the first pair of outer reflective elements are also enclosed. In this way, the mirror surface and the solar energy utilization device can be better protected from dust pollution and atmospheric corrosion. In other embodiments, a Fresnel condenser lens may be served as the transparent top cover to increase the light-concentration ratio of the system.

In a preferred embodiment such as the present embodiment, a Fresnel condenser lens 221 may also arranged on the upper ends of the inner reflective elements 220,220'. It is substantially parallel to the light receiving surface 231 of the photovoltaic panel 230 to converge sunlight toward the light receiving surface 231. In the case of only adopting reflective elements, the light-concentration ratio of the system is generally difficult to exceed three times, so the light-concentration ratio of the system can be increased by further providing the Fresnel lens. A built-in Fresnel condenser lens is adopted in this embodiment, and it can be arranged substantially parallel to the light receiving surface 231 according to its optical characteristics such that the opening flare angles of the first pair of inner reflective elements and the second pair of outer reflective elements can be greater than those in the case without Fresnel lens, thereby obtaining a larger light-concentration ratio. A Fresnel astigmatism lens may also be adopted in other embodiments, and it can be arranged substantially perpendicular to the light receiving surface 231. Moreover, both types of lenses can also be used together.

The Fresnel lens used in the present disclosure may be a single-sided Fresnel lens with one toothed surface and a smooth surface, or a double-sided Fresnel lens with both toothed surfaces. When the Fresnel lens is arranged in a closed container, since it is not affected by external dust, it a double-sided Fresnel lens may be preferably used.

In a preferred embodiment such as the present embodiment, a heat sink 232 may further be arranged under the photovoltaic panel 230 and thermally connected to the photovoltaic panel 230, which can help reduce the temperature of the photovoltaic panel to ensure its working efficiency. The heat sink may also be replaced with another heat energy utilization device in other embodiments, such as a heat absorption container, to make fuller use of energy.

### Embodiment 3

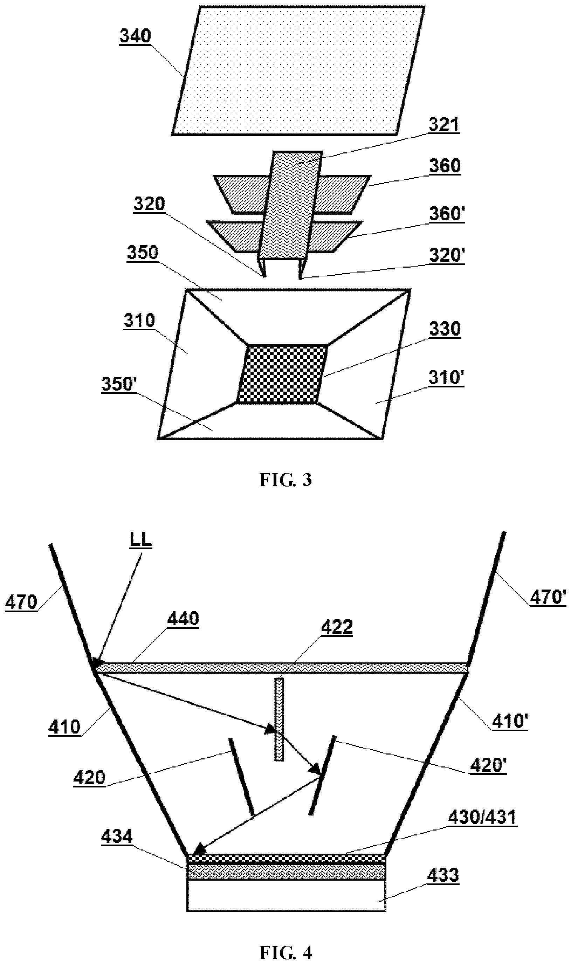

Referring to FIG. 3, a light-concentrating solar energy system according to still another embodiment of the present disclosure is schematically shown in structure after being decomposed along the normal direction of the light receiving surface of a solar energy utilization device (photovoltaic panel). The light-concentrating solar energy system may include a first pair of outer reflective elements 310,310', a first pair of inner reflective elements 320,320', a photovoltaic panel 330, a transparent top cover 340 and a built-in Fresnel condenser lens 321.

The difference between this embodiment and Embodiment 2 is that the transparent top cover 340 adopts a Fresnel condenser lens to obtain a larger light-concentration ratio. Since the outside of the top cover is exposed to the air, a single-sided Fresnel lens may be preferably used, and the toothed surface is arranged downward to facilitate cleaning.

In addition:
In a preferred embodiment such as the present embodiment, a second pair of outer reflective elements 350,350' and a second pair of inner reflective elements 360,360' are further provided. The outer reflective elements 350,350' are respectively arranged on the sides of the outer reflective elements 310,310' such that the two pairs of outer reflective elements are enclosed in a trumpet shape, and form a closed container together with the photovoltaic panel 330 and the top cover 340. The inner reflective elements 360, 360' are arranged between the outer reflective elements 350,350' and face different directions from the inner reflective elements 320,320'. Exemplarily, the two pairs of inner reflective elements are formed in a "#" shape in this embodiment. The additional two pairs of inner and outer reflective elements enables the system to adapt to a wider range of solar deflections.

This embodiment shows a generally conical light-concentrating solar energy system. Because it includes two pairs of inner reflective elements with different orientations and top and inner Fresnel condenser lenses, it can not only obtain a larger light-concentration ratio, but also allow the system to be installed in a fixed manner without the need to be equipped with a sun tracking system. By contrast, many available solar systems with high light-concentration ratios need to be used in conjunction with sun tracking systems.

### Embodiment 4

Referring to FIG. 4, a light-concentrating solar energy system according to another embodiment of the present disclosure may is schematically illustrated in a longitudinal section thereof. The light-concentrating solar energy system may include a first pair of outer reflective elements 410,410', a first pair of inner reflective elements 420,420', a photovoltaic panel 430, a transparent top cover 440 and a built-in Fresnel condenser lens 422.

The difference between this embodiment and Embodiment 2 is that:
1. the transparent top cover 440 adopts a Fresnel condenser lens to obtain a larger light-concentration ratio.
2. the built-in Fresnel lens 422 is a Fresnel astigmatism lens arranged between the inner reflective elements 420,420' and substantially perpendicular to the light receiving surface 431 of the photovoltaic panel 430 for deflecting sunlight toward the light receiving surface 431. The Fresnel astigmatism lens can be a linear astigmatism lens (downward astigmatism direction). The so-called "linear" lens means that the focus center of the lens is a line, rather than focusing on a point. The focal line of the astigmatic lens 422 may be substantially parallel to the light receiving surface 431.

In addition:
In a preferred embodiment such as the present embodiment, two extended reflective elements 470,470' are further provided. They extend upward from the upper ends of the outer reflective elements 410,410' and extend above the top cover 440. These extended reflective elements can further improve the light-concentration ratio of the system.

In a preferred embodiment such as the present embodiment, a heat absorption container 433 instead of the heat sink in Embodiment 2 is further provided to absorb the heat generated by the photovoltaic panel 430. Further preferably, a thermoelectric conversion device 434 such as a thermoelectric diode is further arranged on a heat conduction path of the photovoltaic panel 430 for heat dissipation. Specifically, a thermoelectric conversion device 434 may be arranged between the photovoltaic panel 430 and the heat absorption container 433. The heat generated by the photovoltaic panel is first passed through a thermoelectric conversion device, so that part of the thermal energy is converted into electrical energy to further improve the power generation efficiency, and the remaining thermal energy is absorbed by the heat absorption container to achieve the full use of energy.

The solar system in this embodiment simultaneously adopts a Fresnel (condensing) lens 440 arranged in parallel, a Fresnel (astigmatism) lens 422 arranged vertically and an extended reflective element to obtain a larger light-concentration ratio or to adapt to larger sun deflection angles.

The principle and implementation manners present disclosure has been described above with reference to specific embodiments, which are merely provided for the purpose of understanding the present disclosure and are not intended to limit the present disclosure. It will be possible for those skilled in the art to make variations based on the principle of the present disclosure.

## Claims

1. A light-concentrating solar energy system, comprising:
a first pair of outer reflective elements including two reflective elements which are arranged opposite to each other in a tilted manner, the faces thereof facing each other being reflective surfaces;
a first pair of inner reflective elements arranged between the first pair of outer reflective elements and including two reflective elements which are arranged opposite to each other in a tilted manner, the faces thereof facing each other being reflective surfaces or all faces being reflective surface,
wherein the ends of each pair of tilted reflective elements forming a larger opening are the upper ends thereof, the upper ends face a direction in which sunlight is incident, and each reflective surface is a plane or a curved surface; and
a solar energy utilization device, a light receiving surface thereof arranged at the lower ends of the first pair of outer reflective elements, and the first inner reflective elements being arranged above the light receiving surface.

2. The system according to claim 1, further comprising:
a Fresnel condenser lens arranged on the upper end of the first pair of inner reflective elements and substantially parallel to the light receiving surface of the solar energy utilization device for converging sunlight toward the light receiving surface.

3. The system according to claim 1 or 2, further comprising:
a Fresnel astigmatism lens arranged between the first pair of inner reflective elements and substantially perpendicular to the light receiving surface of the solar energy utilization device for deflecting sunlight toward the light receiving surface.

4. The system according to any one of claims 1 to 3, further comprising:
a transparent top cover which closes the upper ends of the first pair of outer reflective elements, the light receiving surface of the solar energy utilization device closing the lower ends of the first pair of outer reflective elements.

5. The system according to claim 4,
wherein the transparent top cover is a Fresnel condenser lens.

6. The system according to any one of claims 1 to 5, further comprising:
a second pair of outer reflective elements including two reflective elements which face one another in a tilted manner and are respectively arranged on the sides of the first pair of outer reflective elements so that the two pairs of outer reflective elements are enclosed in a trumpet shape.

7. The system according to claim 6, further comprising:
the second pair of inner reflective elements arranged between the second pair of outer reflective elements and facing different directions from the first pair of inner reflective elements.

8. The system according to any one of claims 1 to 7, further comprising:
at least one extended reflective element extending upward from the upper end of any outer reflective element.

9. The system according to any one of claims 1 to 8,
wherein each reflective surface is a plane, and each angle between an outer reflective element and the light receiving surface of the solar energy utilization device is greater than or equal to each angle between an inner reflective element and the light receiving surface of the solar energy utilization device.

10. The system according to any one of claims 1 to 8,
wherein the solar energy utilization device includes a photovoltaic conversion device, and further includes a heat sink or a heat absorption container arranged below the photovoltaic conversion device and thermally connected to the photovoltaic conversion device.

11. The system according to claim 10,
wherein the solar energy utilization device further includes a thermoelectric conversion device arranged on a heat conduction path of the photovoltaic panel for heat dissipation.
